# EUROPEAN PATENT APPLICATION

(11) **EP 2 802 010 A1**
(43) Date of publication of application: **12.11.2014**
(21) Application number: 14166095.1
(22) Date of filing: 25.04.2014
(51) Int. Cl.: H01L 27/146

(54) **Integrated circuit stack with low profile contacts**

(30) Priority: 06.05.2013 US 201313887664
(71) Applicant: OmniVision Technologies, Inc., Santa Clara, CA 95054 (US)
(72) Inventor: Massetti, Dominic, San Jose CA California 95125 (US)
(74) Representative: Hackney, Nigel John

(57) **Abstract**

An integrated circuit system includes first and second device wafers, each having lateral sides along which a plurality of T-contacts are disposed. The first and second device wafers are stacked together and the lateral sides of the first and second device wafers are aligned such that each one of the plurality of T-contacts of the first device wafer is coupled to a corresponding one of the plurality of T-contacts of the second device wafer. A plurality of solder balls are attached to the lateral sides and are coupled to the plurality of T-contacts. A circuit board includes a recess with a plurality of contacts disposed along lateral sides within the recess. The first and second device wafers are attached to the circuit board such that each one of the plurality of solder balls provide a lateral coupling between the first and second device wafers and the circuit board.

## Description

### BACKGROUND INFORMATION

### Field of the Disclosure

The present invention relates generally semiconductor processing. More specifically, examples of the present invention are related to semiconductor processing of stacked integrated circuit systems.

### Background

As integrated circuit technologies continue to advance, there are continuing efforts to increase performance and density, improve form factor, and reduce costs. The implementation of stacked three dimensional integrated circuits have been one approach that designers sometimes use to realize these benefits. The advances in wafer bonding with very precise alignments make it possible to fabricate stacked chips on wafer-level. The possible applications could include logic chip bonding to memory, image sensors, among others. This offers the advantage of smaller form factor, higher performance, and lower cost.

A key challenge when implementing stacked three dimensional complementary metal-oxide semiconductor ("CMOS") image sensors, which continue to get smaller and faster, relates to keeping the overall package height as short as possible as there is a continuing trend towards smaller profile devices. For example, smartphones and tablet computers continue to become thinner and lighter as new models are released, which therefore requires image sensor modules to be shorter in order to fit inside the thinner smartphones and tablet computers. In addition, the stacking of integrated circuits that have resulted in the continuing efforts to increase performance and density and improve form factor has introduced challenges in dealing with the dissipation of heat created with the stacked integrated circuit dice.

### BRIEF DESCRIPTION OF THE DRAWINGS

Non-limiting and non-exhaustive examples of the present invention are described with reference to the following figures, wherein like reference numerals refer to like parts throughout the various views unless otherwise specified.
FIG. **1A** is a cross-section diagram illustrating an example of first and second device wafers that are stacked and bonded together in an example imaging system prior to being separated in accordance with the teachings of the present invention.
FIG. **1B** is a bottom-up view diagram illustrating an example of first and second device wafers that are stacked and bonded together prior to being separated in an example imaging system in accordance with the teachings of the present invention.
FIG. 2A is a cross-section diagram illustrating another example of first and second device wafers that are stacked and bonded together in an example imaging system prior to being separated in accordance with the teachings of the present invention.
FIG. 2B is a bottom-up view diagram illustrating another example of first and second device wafers that are stacked and bonded together prior to being separated in an example imaging system in accordance with the teachings of the present invention.
FIG. 3A is a side-view diagram illustrating an example of an example imaging system including an integrated circuit system being attached within an example recess in a circuit board in accordance with the teachings of the present invention.
FIG. 3B is a side-view diagram illustrating an example of an example imaging system including an integrated circuit system that has been within an example recess in a circuit board in accordance with the teachings of the present invention.
FIG. 4 is a diagram illustrating one example of an imaging system including a pixel array having image sensor pixels included in an integrated circuit system attached within an example recess in a circuit board in accordance with the teachings of the present invention.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

As will be shown, methods and apparatuses directed to an image sensing integrated circuit stack with low profile contacts are disclosed. In the following description, numerous specific details are set forth in order to provide a thorough understanding of the present invention. In the following description numerous specific details are set forth to provide a thorough understanding of the embodiments. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects.

Reference throughout this specification to "one embodiment," an embodiment, "one example," or "an example" means that a particular feature, structure, or characteristic described in connection with the embodiment or example is included in at least one embodiment or example of the present invention. Thus, the appearances of the phrases such as "in one embodiment" or "in one example" in various places throughout this specification are not necessarily all referring to the same embodiment or example. Furthermore, the particular features, structures, or characteristics may be combined in any suitable manner in one or more embodiments or examples. The following is a detailed description of the terms and elements used in the description of examples of the present invention by referring to the accompanying drawings.

As will be shown, an imaging system including an integrated circuit stack having low profile contacts in accordance with the teachings of the present invention reduces the overall thickness of a camera module by moving the die electrical connections from the bottom of the integrated circuit stack to the lateral sides of the integrated circuit stack. By moving the die electrical connections to the lateral sides, the thickness of the camera module is reduced because any additional thickness required by solder balls on the bottom of the integrated circuit stack is moved to the lateral sides of the integrated circuit stack. In addition, this allows the chip surface on the bottom of a device wafer of the integrated circuit stack to be coated with a heat conductive interface material, such as for example a metal coating and/or a heat conductive epoxy, and placed adjacent to a metal heat sink, which can provide additional heat dissipation in accordance with the teachings of the present invention.

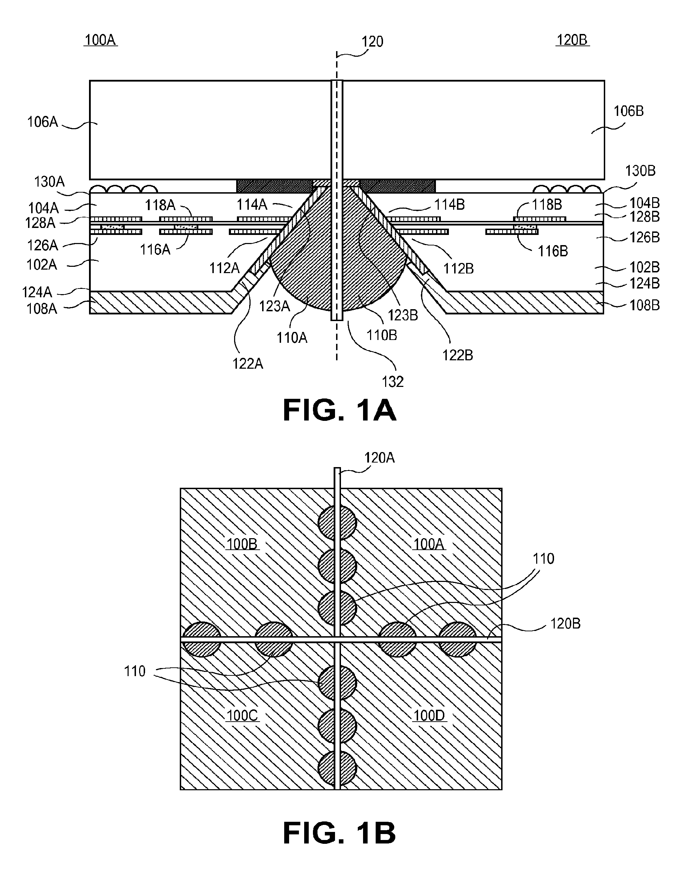

To illustrate, **FIG. 1A** is a cross-section diagram illustrating an example of an integrated circuit stack 100A and an integrated circuit stack 100B during fabrication prior to being separated in accordance with the teachings of the present invention. Specifically, in the example depicted in **FIG. 1A**, two device wafers are stacked face-to-face with their top metal interconnects connected together. **FIG. 1A** also shows that integrated circuit stack 100A includes a lens stack 106A stacked with second device wafer 104A, and that integrated circuit stack 100B includes a lens stack 106B stacked with second device wafer 104B. In the example, integrated circuit stacks 100A and 100B are included in imaging systems such that second device wafers 104A and 104B therefore include image sensor chips. In the example, first device wafers 102A and 102B may include memory chips, processor chips, application specific integrated circuit (ASIC) chips, or the like. The combined stacked wafers are then separated into the different integrated circuit stacks 100A and 100B by being sawed at die saw line 120 as shown.

In other examples, it is appreciated that stacked first and second device wafers may include a variety of combinations, such as for example but not limited to memory chips stacked on top of image sensors, memory chips stacked on top of processor chips, processor chips stacked on top of image sensors, chips that are fabricated with different fabrication processes, stacked smaller chips whose separate yields are higher than one larger chip, or stacked chips that save on an integrated circuit system footprint, increase speed and/or decrease power.

In the specific example depicted in **FIG. 1A**, integrated stack 100A includes a first device wafer 102A stacked face-to-face with second device wafer 104A, and integrated stack 100B includes a first device wafer 102B stacked face-to-face with second device wafer 104B. In the illustrated example, a front side 126A of first device wafer 102A is stacked face-to-face with a front side 128A of second device wafer 104A at a bonding interface between first and second device wafers 102A and 104A such that an image sensor included in second device wafer 104A is illuminated through a back side 130A of second device wafer 104A through a lens stack 106A. A front side 126B of first device wafer 102B is stacked face-to-face with a front side 128B of second device wafer 104B at a bonding interface between first and second device wafers 102B and 104B such that an image sensor included in second device wafer 104B is illuminated through a back side 130B of second device wafer 104B through a lens stack 106B. In other examples (not shown), it is appreciated that the back sides of the device wafers may be bonded together in the integrated circuit stacks, or that the front sides of one of the device wafers may be bonded to the back sides of the other device wafers in the integrated circuit stacks in accordance with the teachings of the present invention.

As shown in the illustrated example, first device wafers 102A and 102B have substantially the same scribe dimensions as second device wafers 104A and 104B such that a lateral side 122A of first device wafer 102A is aligned with a lateral side 123A of second device wafer 104A, and a lateral side 122B of first device wafer 102B is aligned with a lateral side 123B of second device wafer 104B. Accordingly, a T-contact 112A along lateral side 122A of first device wafer 102A is coupled to a T-contact 114A along lateral side 123A of second device wafer 104B as shown. Similarly, a T-contact 112B along lateral side 122B of first device wafer 102B is coupled to a T-contact 114B along lateral side 123B of second device wafer 104B as shown. In addition, metal interconnects 116A proximate to the front side 126A of first device wafer 102A are coupled to metal interconnects 118A proximate to the front side 128A of second device wafer 104A through the bonding interface between first and second device wafers 102A and 104A. Similarly, metal interconnects 116B proximate to the front side 126B of first device wafer 102B are coupled to metal interconnects 118B proximate to the front side 128B of second device wafer 104B through the bonding interface between first and second device wafers 102B and 104B.

In the example depicted in **FIG. 1A**, a solder masks 108A and 108B are shown being deposited over portions of the back sides 124A and 124B of first device wafers 102A and 102B leaving an opening that exposes a "V" region 132 between the integrated stacks 100A and 100B, which exposes the plurality of T-contacts 112A, 112B, 114A and 114B disposed along the lateral sides 122A, 122B, 123A, and 123B of the first and second device wafers 102A, 102B, 104A and 104B as shown. A solder ball, shown as 110A and 110B, may then be deposited in the "V" region 132 to provide an electrical coupling to the plurality of T-contacts 112A, 112B, 114A and 114B along the lateral sides 122A, 122B, 123A, and 123B of the first and second device wafers 102A, 102B, 104A and 104B as shown. In the example, when the integrated circuit stacks 100A and 100B are separated by sawing the dice along die saw line 120 as shown, the solder ball is then separated into the two halves, as illustrated with solder ball 110A and solder ball 110B. After being separated, it is appreciated that solder balls 110A and 110B can be heated and reshaped as needed, and that in one example, only a small number of solder balls 110A and 110B are needed so that solder balls 110A and 110B can be very large in accordance with the teachings of the present invention.

**FIG. 1B** is a bottom-up view diagram illustrating an example of a plurality of device wafers that are stacked and bonded together in integrated circuit stacks 100A, 100B, 100C and 100D prior to being sawed apart in accordance with the teachings of the present invention. In one example, integrated circuit stacks 100A, 100B, 100C and 100D in **FIG. 1B** are substantially similar to integrated circuit stacks 100A and 100B in **FIG. 1A** in accordance with the teachings of the present invention. In the depicted illustration, solder balls 110 are coupled to the plurality of T-contacts arranged along lateral sides of the plurality of device wafers that are exposed in the "V" regions between the integrated circuit stacks 100A, 100B, 100C and 100D. **FIG. 1B** also shows that integrated circuit stacks 100A, 100B, 100C and 100D are separated into individual stacks by sawing along die saw lines 120A and 120B through solder balls 110 in accordance with the teachings of the present invention. After being separated, it is appreciated that solder balls 110 can be heated and reshaped as needed.

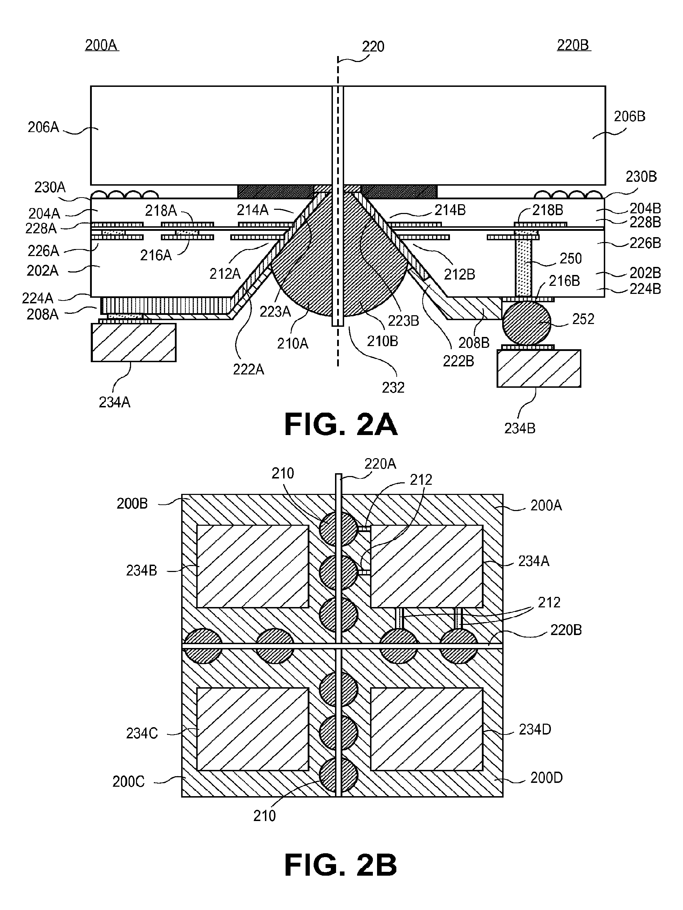

**FIG. 2A** is a cross-section diagram illustrating another example of first and second device wafers that are stacked and bonded together in integrated circuit stacks 200A and 200B during fabrication prior to being separated in accordance with the teachings of the present invention. It is noted that integrated circuit stacks 200A and 200B of **FIG. 2A** share many similarities with integrated circuit stacks 100A and 100B of **FIG. 1A** and that similarly named and numbered elements referenced below are coupled and function similar to as described above.

For instance, similar to **FIG. 1A**, integrated stack 200A of **FIG. 2A** includes a first device wafer 202A stacked face-to-face with second device wafer 204A, and integrated stack 200B includes a first device wafer 202B stacked face-to-face with second device wafer 204B. In the illustrated example, a front side 226A of first device wafer 202A is stacked face-to-face with a front side 228A of second device wafer 204A at a bonding interface between first and second device wafers 202A and 204A such that an image sensor included in second device wafer 204A is illuminated through a back side 230A of second device wafer 204A through a lens stack 206A. A front side 226B of first device wafer 202B is stacked face-to-face with a front side 228B of second device wafer 204B at a bonding interface between first and second device wafers 202B and 204B such that an image sensor included in second device wafer 204B is illuminated through a back side 230B of second device wafer 204B through a lens stack 206B. One difference between integrated circuit stacks 200A and 200B of **FIG. 2A** and integrated circuit stacks 100A and 100B of **FIG. 1A** is that in integrated circuit stacks 200A and 200B of **FIG. 2A****,** first device wafers 202A and 202B are intermediate carriers or interposer dice that are disposed between second device wafers 204A and 204B and second dice 234A and 234B, respectively, as shown. In the illustrated example, it is appreciated that second dice 234A and 234B are separate wafers and are on different planes as shown.

As shown in the example of **FIG. 2A****,** first device wafers 202A and 202B have substantially the same scribe dimensions as second device wafers 204A and 204B such that a lateral side 222A of first device wafer 202A is aligned with a lateral side 223A of second device wafer 204A, and a lateral side 222B of first device wafer 202B is aligned with a lateral side 223B of second device wafer 204B. Accordingly, a T-contact 212A along lateral side 222A of first device wafer 202A is coupled to a T-contact 214A along lateral side 223A of second device wafer 204B as shown. Similarly, a T-contact 212B along lateral side 222B of first device wafer 202B is coupled to a T-contact 214B along lateral side 223B of second device wafer 204B as shown. In addition, metal interconnects 216A proximate to the front side 226A of first device wafer 202A are coupled to metal interconnects 218A proximate to the front side 228A of second device wafer 204A through the bonding interface between first and second device wafers 202A and 204A.

In the example depicted in **FIG. 2A****,** T-contact 212A extends along lateral side 222A to the back side 224A of first device wafer 202A to provide an electrical coupling to second die 234A. In the example depicted in **FIG. 2A****,** metal interconnect 216B proximate to the back side 224B of first device wafer 202B is coupled to metal interconnect 218B proximate to the front side 228B of second device wafer 204B through a through silicon via (TSV) 250 through the bonding interface between first and second device wafers 202B and 204B. In addition, the example shown in **FIG. 2A** shows that the metal interconnect 216B is further coupled to the second die 234B through solder ball 252 to provide an electrical coupling to second die 234B.

In another example, it is noted that the electrical couplings from both first and second dice 234A and 234B to their respective stacked wafers may all be provided by T-contacts, similar to for example T-contact 212A, instead of the combination of T-contacts and TSVs with solders balls as illustrated in the example of FIG. 2A. Similarly, in yet another example, it is appreciated that the electrical couplings from both first and second dice 234A and 234B to their respective stacked wafers may all be provided with TSVs and solder balls, similar to for example TSV 250 and solder ball 252, instead of the combination of T-contacts and TSVs with solders balls as illustrated in the example of **FIG. 2A****.** The combined stacked wafers and dice are then separated into the different integrated circuit stacks 200A and 200B by being sawed at die saw line 220 as shown.

In the example depicted in **FIG. 2A****,** a solder masks 208A and 208B are shown being deposited over portions of the back sides 224A and 224B of first device wafers 202A and 202B leaving an opening that exposes a "V" region 232 between the integrated stacks 200A and 200B, which exposes the plurality of T-contacts 212A, 212B, 214A and 214B disposed along the lateral sides 222A, 222B, 223A, and 223B of the first and second device wafers 202A, 202B, 204A and 204B as shown. A solder ball, shown as 210A and 210B, may then be deposited in the "V" region 232 to provide an electrical coupling to the plurality of T-contacts 212A, 212B, 214A and 214B along the lateral sides 222A, 222B, 223A, and 223B of the first and second device wafers 202A, 202B, 204A and 204B as shown. In the example, when the integrated circuit stacks 200A and 200B are separated by sawing the dice along die saw line 220 as shown, the solder ball is then separated into the two halves, as illustrated with solder ball 210A and solder ball 210B. After being separated, it is appreciated that solder balls 210A and 210B can be heated and reshaped as needed in accordance with the teachings of the present invention.

**FIG. 2B** is a bottom-up view diagram illustrating another example of a plurality of device wafers that are stacked and bonded together in integrated circuit stacks 200A, 200B, 200C and 200D prior to being sawed apart in accordance with the teachings of the present invention. It is appreciated that integrated circuit stacks 200A, 200B, 200C and 200D in **FIG. 2B** are substantially similar to integrated circuit stacks 200A and 200B in **FIG. 2A** in accordance with the teachings of the present invention. **FIG. 2B** also shows the bottoms of second integrated circuit dice 234A, 234B, 234C and 234D, which in one example are attached to the interposer dice of the integrated circuit stacks 200A, 200B, 200C and 200D. In the depicted illustration, solder balls 210 are coupled to the plurality of T-contacts arranged along lateral sides of the plurality of device wafers that are exposed in the "V" regions between the integrated circuit stacks 200A, 200B, 200C and 200D. In the example of **FIG. 2B****,** solder balls 210 are also coupled to second die 234A of integrated circuit stack 200A through the T-contacts 212 as shown. In integrated circuit stacks 200B, 200C and 200D, it is appreciated that second dice 234B, 234C and 234D may be coupled to their respective interposer dice of integrated circuit stacks 200B, 200C and 200D, respectively, through solder balls and/or through TSVs, similar to integrated circuit stack 200B as shown in **FIG. 2A. FIG. 2B** also shows that integrated circuit stacks 200A, 200B, 200C and 200D are separated into individual stacks by sawing along die saw lines 220A and 220B through solder balls 210 in accordance with the teachings of the present invention. After being separated, it is appreciated that solder balls 210 can be heated and reshaped as needed.

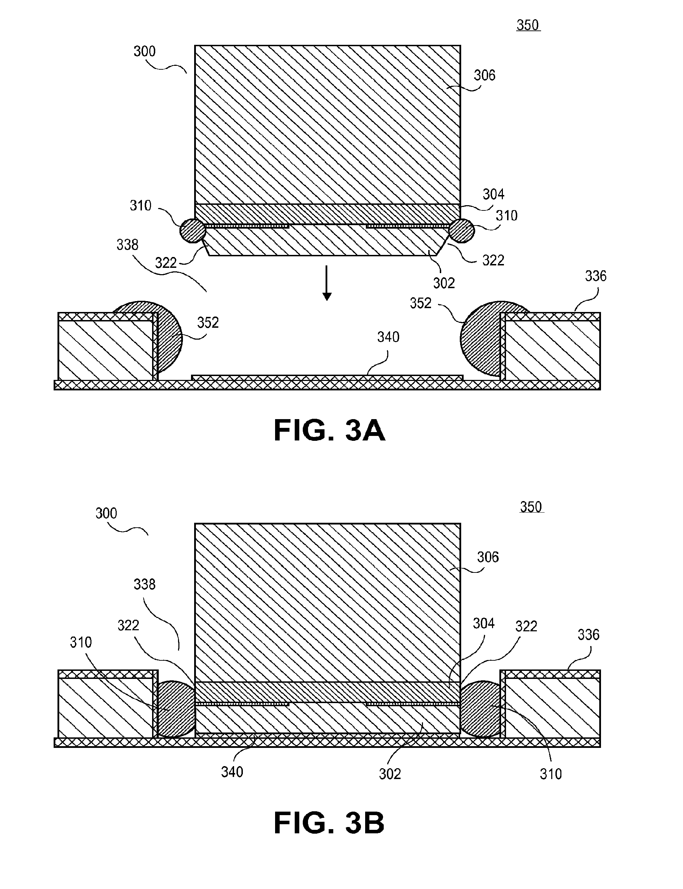

**FIG. 3A** is a side-view diagram illustrating an example of an example imaging system 350 including an integrated circuit stack 300 with low profile contacts that is to be attached to a circuit board 336 in accordance with the teachings of the present invention. In one example, it is appreciated that example integrated circuit stack 300 shares many similarities with example integrated circuit stacks 100A and 100B of **FIG. 1A** and that similarly named and numbered elements referenced below are coupled and function similar to as described above. As shown in the depicted example, integrated circuit stack 300 includes a first device wafer 302, a second device wafer 304 and a lens stack 306 stacked together as shown. Solder balls 310 are attached to lateral sides 322 and are coupled to a plurality of T-contacts included in integrated circuit stack 300 that are arranged along lateral sides 322 in accordance with the teachings of the present invention.

As shown in **FIG. 3A****,** an example circuit board 336 includes a recess 338 defined on a surface thereon. In the example, the circuit board 336 is a copper clad circuit board and includes a plurality of contacts 352 disposed along lateral sides within the recess 338 defined in circuit board 336. In the depicted example, a heat conductive interface material 340, such as for example a metal and/or a heat conductive epoxy, is coated on the surface in recess 338 onto which the integrated circuit stack 300 is attached to provide high heat transfer between integrated circuit stack 300 and circuit board 336. In another example, it is appreciated that the heat conductive interface material 340 may be coated onto the surface of integrated circuit stack 300 within recess 338 that makes contact with circuit board 336.

**FIG. 3B** is a side-view diagram illustrating an example of the example imaging system 350 including integrated circuit stack 300 with low profile contacts that has been attached to circuit board 336 in accordance with the teachings of the present invention. In the example, it is appreciated that integrated circuit stack 300 and circuit board 336 of **FIG. 3B** are substantially similar to the integrated circuit stack 300 and circuit board 336 discussed above with respect to **FIG. 3A** and that similarly named and numbered elements referenced below are coupled and function similar to as described above.

As shown in the example depicted in **FIG. 3B****,** integrated circuit stack 300, including first device wafer 302, second device wafer 304 and lens stack 306 are attached to the circuit board 336 within the recess 338 such that each one of the plurality of solder balls 310 provide a lateral coupling between each one plurality of T-contacts of the first and second device wafers 302 and 304 and the plurality of contacts disposed along lateral sides within the recess 338 of the circuit board 336 in accordance with the teachings of the present invention. In addition, **FIG. 3B** shows that the heat conductive interface material 340 is thermally coupled between the first and second device wafers 302 and 304 and an inside surface of the recess 338 of the circuit board 336 to which integrated circuit is attached. In one example, circuit board 336 further includes a heat sink that is thermally coupled to the inside surface of the recess 338 of the circuit board 336 to provide additional heat dissipation from integrated circuit stack 300 through circuit board 336 in accordance with the teachings of the present invention.

It is appreciated that with each one of the plurality of solder balls 310 providing a lateral coupling between each one plurality of T-contacts of the first and second device wafers 302 and 304 and the plurality of contacts disposed along lateral sides within the recess 338 of the circuit board 336, the overall thickness of a camera module including imaging system 350 is reduced because die electrical connections are moved from the bottom of integrated circuit stack 300 to the lateral sides 322. Thus, the overall height of a camera module including imaging system 350 is shorter, which enables electronic devices utilizing a camera module including imaging system 350 to be thinner in accordance with the teachings of the present inventions. Furthermore, it is appreciated that with the plurality of solder balls 310 moved from the bottom of integrated circuit stack 300 to the lateral sides 322, the heat conductive interface material 340 that can now provide an improve thermal coupling between the first and second device wafers 302 and 304 and circuit board 336 to provide improved heat dissipation in accordance with the teachings of the present invention.

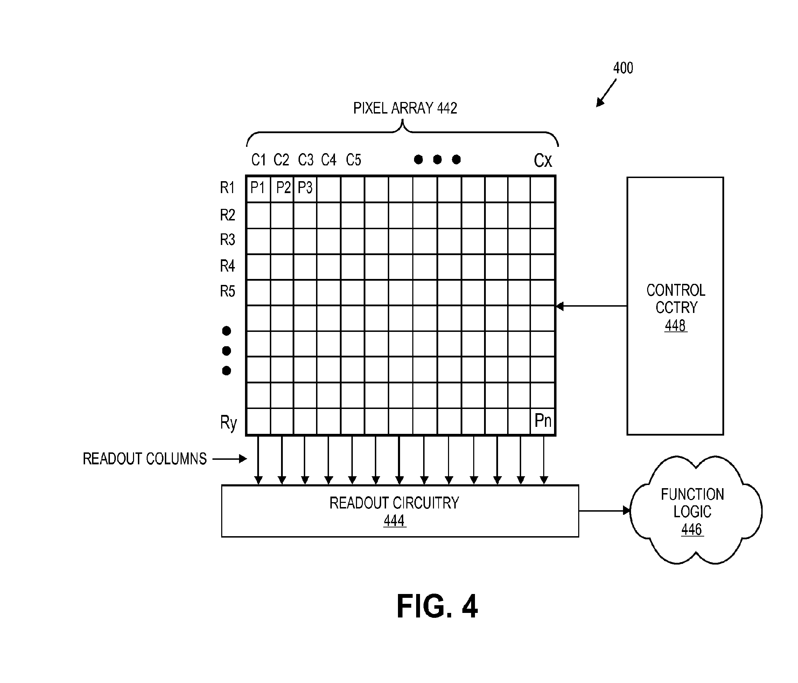

**FIG. 4** is a diagram illustrating one example of an imaging system 400 including an example pixel array 442 having a plurality of image sensor pixels included in an example integrated circuit system including an integrated circuit stack with low profile contacts in accordance with the teachings of the present invention. As shown in the depicted example, imaging system 400 includes pixel array 442 coupled to control circuitry 448 and readout circuitry 444, which is coupled to function logic 446.

In one example, pixel array 442 is a two-dimensional (2D) array of image sensor pixels (*e.g*., pixels P1, P2 ..., Pn). In one example, pixel array 442 is included in an integrated circuit system included in an integrated circuit stack with low profile contacts, such as for example the integrated circuit stack examples discussed above in **FIGs**. **1A**, **1B**, **2A, 2B****,** **3A** and 3B. As illustrated, each pixel is arranged into a row *(e.g.,* rows R1 to Ry) and a column *(e.g.,* column C1 to Cx) to acquire image data of a person, place, object, etc., which can then be used to render a 2D image of the person, place, object, etc.

In one example, after each pixel has acquired its image data or image charge, the image data is readout by readout circuitry 444 and then transferred to function logic 446. In various examples, readout circuitry 404 may include amplification circuitry, analog-to-digital (ADC) conversion circuitry, or otherwise. Function logic 446 may simply store the image data or even manipulate the image data by applying post image effects *(e.g.,* crop, rotate, remove red eye, adjust brightness, adjust contrast, or otherwise). In one example, readout circuitry 444 may readout a row of image data at a time along readout column lines (illustrated) or may readout the image data using a variety of other techniques (not illustrated), such as a serial readout or a full parallel readout of all pixels simultaneously.

In one example, control circuitry 448 is coupled to pixel array 442 to control operational characteristics of pixel array 442. For example, control circuitry 448 may generate a shutter signal for controlling image acquisition. In one example, the shutter signal is a global shutter signal for simultaneously enabling all pixels within pixel array 442 to simultaneously capture their respective image data during a single acquisition window. In another example, the shutter signal is a rolling shutter signal such that each row, column, or group of pixels is sequentially enabled during consecutive acquisition windows.

The above description of illustrated examples of the present invention, including what is described in the Abstract, are not intended to be exhaustive or to be limitation to the precise forms disclosed. While specific embodiments of, and examples for, the invention are described herein for illustrative purposes, various equivalent modifications are possible without departing from the broader spirit and scope of the present invention. Indeed, it is appreciated that the specific example voltages, currents, frequencies, power range values, times, etc., are provided for explanation purposes and that other values may also be employed in other embodiments and examples in accordance with the teachings of the present invention.

These modifications can be made to examples of the invention in light of the above detailed description. The terms used in the following claims should not be construed to limit the invention to the specific embodiments disclosed in the specification and the claims. Rather, the scope is to be determined entirely by the following claims, which are to be construed in accordance with established doctrines of claim interpretation. The present specification and figures are accordingly to be regarded as illustrative rather than restrictive.

## Claims

1. An integrated circuit system, comprising:
a first device wafer having lateral sides, the first device wafer further including a plurality of T-contacts disposed along the lateral sides of the first device wafer;
a second device wafer having lateral sides, the second device wafer further including a plurality of T-contacts disposed along the lateral sides of the second device wafer, wherein the first and second device wafers are stacked together, wherein the lateral sides of the first device wafer are aligned with the lateral sides of the second device wafer such that each one of the plurality of T-contacts of the first device wafer is coupled to a corresponding one of the plurality of T-contacts of the second device wafer;
a plurality of solder balls attached to the lateral sides of the first and second wafers and coupled to the plurality of T-contacts of the first and second device wafers; and
a circuit board having a recess defined on a surface thereon, the circuit board including a plurality of contacts disposed along lateral sides within the recess, wherein the first and second device wafers are attached to the circuit board within the recess such that each one of the plurality of solder balls provide a lateral coupling between each one plurality of T-contacts of the first and second device wafers and the plurality of contacts disposed along lateral sides within the recess of the circuit board.

2. The integrated circuit system of claim 1 wherein the first and second device wafers each include front and back sides such that one of the front and back sides of the first device wafer is attached to one of the front and back sides of the second device wafer at a bonding interface between the first and second device wafers.

3. The integrated circuit system of claim 2 wherein the front side of the first device wafer is attached to the front side of the second device wafer.

4. The integrated circuit system of claim 1 wherein the each of the first and second device wafers further include metal interconnects, wherein the metal interconnects of the first device wafer are coupled to the metal interconnects of the second device wafer through a bonding interface between the first and second device wafers.

5. The integrated circuit system of claim 4 further comprising one or more through-silicon vias (TSVs) through which the metal interconnects of the first device wafer are coupled to the metal interconnects of the second device wafer through the bonding interface between the first and second device wafers.

6. The integrated circuit system of claim 1 wherein one of the first and second device wafers comprises an image sensor chip and an other one of the first and second device wafers comprises a memory chip.

7. The integrated circuit system of claim 1 wherein one of the first and second device wafers comprises a memory chip and an other one of the first and second device wafers comprises a processor chip.

8. The integrated circuit system of claim 1 further comprising a heat conductive interface material thermally coupled between the first and second device wafers and an inside surface of the recess of the circuit board to which the first and second device wafers are attached.

9. The integrated circuit system of claim 1 wherein the circuit board further includes a heat sink thermally coupled to the inside surface of the recess of the circuit board to which the first and second device wafers are attached through the heat conductive interface material.

10. An imaging system, wherein:
the first device according to any one of the above claims is an image sensor, wherein the image sensor wafer includes a pixel array having a plurality of image sensor pixels;
the second device according to any one of the above claims is an image sensor processor wherein the image sensor processor wafer includes control circuitry coupled to the pixel array to control operation of the pixel array and readout circuitry coupled to the pixel array to readout image data from the plurality of image sensor pixels;

11. The imaging system of claim 10 further comprising function logic included in the image sensor processor wafer and coupled to the readout circuitry to store the image data readout from the plurality of image sensor pixels.

12. The imaging system of claim 10 wherein a front side of the image sensor wafer is attached to a front side of the image sensor processor wafer at a bonding interface between the image sensor wafer and the image sensor processor wafer.

13. The imaging system of claim 10 wherein the each of the image sensor wafer and the image sensor processor wafer further include metal interconnects, wherein the metal interconnects of the image sensor wafer are coupled to the metal interconnects of the image sensor processor wafer through a bonding interface between the image sensor wafer and the image sensor processor wafer.

14. The imaging system of claim 10 further comprising a lens stack attached to a back side of the image sensor wafer such that the pixel array is adapted to be illuminated through the lens stack and through the back side of the image sensor wafer and wherein a front side of the image sensor wafer is attached to image sensor processor wafer at a bonding interface between the image sensor wafer and the image sensor processor wafer.

15. The imaging system of claim 10 further comprising a heat conductive interface material thermally coupled between the image sensor processor wafer and an inside surface of the recess of the circuit board to which the image sensor and image sensor processor wafers are attached.
